# EUROPEAN PATENT SPECIFICATION

(11) **EP 3 704 497 B1**
(45) Date of publication and mention of the grant of the patent: **21.07.2021**
(21) Application number: 18811347.6
(22) Date of filing: 29.10.2018
(51) Int. Cl.: G01R 19/00

(54) **METHOD FOR MAKING THE COMPARISON BETWEEN A CONTINUOUS VALUE ANALOGUE SIGNAL AND A CONTINUOUS VALUE DIGITAL SIGNAL AND CIRCUIT ARCHITECTURE CONFIGURED TO CARRY OUT THE AFORESAID METHOD**
VERFAHREN ZUR ANSTELLUNG EINES VERGLEICHS ZWISCHEN EINEM KONTINUIERLICHEN ANALOGEN SIGNAL UND EINEM KONTINUIERLICHEN DIGITALEN SIGNAL UND SCHALTUNGSARCHITEKTUR ZUR DURCHFÜHRUNG DIESES VERFAHRENS
PROCÉDÉ POUR EFFECTUER LA COMPARAISON ENTRE UN SIGNAL ANALOGIQUE DE VALEUR CONTINUE ET UN SIGNAL NUMÉRIQUE DE VALEUR CONTINUE ET ARCHITECTURE DE CIRCUIT CONFIGURÉE POUR METTRE EN OEUVRE LE PROCÉDÉ PRÉCITÉ

(30) Priority: 30.10.2017 IT 201700123149
(43) Date of publication of application: 09.09.2020
(73) Proprietor: Fondazione Bruno Kessler, 38122 Trento (IT)
(72) Inventor: GOTTARDI, Massimo, 38122 Trento (IT); ZOU, Yu, 38122 Trento (IT)
(74) Representative: Marchioro, Paolo
(86) International application number: PCT/IB2018/058453
(87) International publication number: WO 2019/087041

(56) References cited:
- WO-A1-2017/076748
- US-A- 3 409 830
- US-A- 4 484 291
- US-A1- 2013 099 090

## Description

The invention relates to a method for making the comparison between a continuous value analogue signal and a continuous value digital signal.

The invention also relates to a circuit architecture configured to carry out the aforesaid method of the invention.

The project leading to this application has received funding from the European Union's Horizon 2020 research and innovation programme under grant agreement No 653355.

It is known that information within the fields of electronics and informatics may be represented mainly in two ways: by means of analogue type signals or by means of numerical or digital type signals. The information content with the first is represented by the values that the physical signal may take on, and therefore it continuously varies within the dynamics of the signal.

The information content in the case of digital signals instead is again represented by the values that the physical signal may take on, but in this case the significant values are a finite set.

It is just as known that in the various implementations of electronic or informatics systems, there is the need to process such signals in order to interpret and/or modify the contents thereof. With regard to processing analogue signals, more specifically, it provides directly acting on the physical signal. Therefore here, the processing processes continuous-time and continuous-value signals.

The processing of digital type signals instead provides acting on the information extracted from the physical signal transporting it.

The digital (or numerical) processing of the signal therefore intrinsically processes discrete-time and discrete-value signals.

The analogue processing limits of the analogue signals consist in having to build circuits capable of directly acting on the analogue signals themselves.

A further limit of this type of processing is due to the presence of the intrinsic noise in the analogue signal or caused by the analogue processing circuit built to process the signal itself.

Such problems have encouraged operators to develop techniques for representing the information and for processing which are immune or less sensible thereto. This has resulted in the tendency to convert the analogue signals into digital signals capable of being processed by electronic computers. However, the limit of such conversion consists in the fact that inevitably the digital signal obtained from a corresponding analogue signal has less information than the latter.

Having made such premises of general nature, it is known that there is the need in certain applications to compare an analogue type signal with a digital type signal, the latter representing for example a threshold value.

While considering what is said above, in order to compare such two signals which are different in nature, the background art tends to convert the analogue signal into a digital signal, to then compare them by means of a digital processing system.

The background art possibly also provides carrying out the conversion in opposite direction, and that is to convert the digital signal into a corresponding analogue signal, and then to compare them by means of a conveniently built analogue circuit system.

Both such approaches have certain drawbacks, especially if such comparison is to be implemented by minimizing the voltage consumption, the use of integrated electronic components and, accordingly, the space in which to make such processing circuit.

Such needs are highly felt, for example, in the case of an electronic circuit for processing digital images to be made on the same silicon substrate in which the pixel array of the sensor is defined.

Indeed, both such approaches firstly require the conversion of one of the two signals into the form of representation of the second.

Moreover, if the comparison of two analogue type signals is to be made, as mentioned above, it requires the definition of an analogue type electronic circuit, which naturally has high voltage consumption. Furthermore, again disadvantageously, if the second signal is a threshold, such analogue approach does not allow modifying the value thereof in an easy and quick manner.

The comparison made in purely digital manner also requires making an integrated circuit with a non-negligible number of transistors and therefore with the significant use of the silicon surface.

Prior art US4484291 and US3409830 teach circuits that compare two analog signals, the latter using ramp signals. Prior art WO2017/076748 and US2013/099090 teach ramp-comparator type ADC's for imaging pixel arrays.

The present invention intends overcoming all the drawbacks mentioned.

In particular, the object of the invention is to define a method and propose a circuit architecture for making the comparison between a continuous value analogue signal and a continuous value digital signal which allows having a smaller voltage consumption with respect to a method and relative comparison circuit of the purely analogue type.

It is a further object of the invention to define a method and propose a relative circuit architecture which allow ensuring increased flexibility in selecting and varying the value of the second signal - for example a threshold value - to be compared with the first signal, with respect to a method and a related comparison circuit of purely analogue type.

It is also an object of the invention to define a method and propose a circuit architecture which allow reducing the number of integrated electronic components required for the implementation thereof with respect to a method and a relative comparison circuit of purely digital type.

Accordingly, the object of the invention is to define a method and propose a circuit architecture which allow reducing the silicone area occupied with respect to a method and a relative comparison circuit of the purely digital type. The aforesaid objects are achieved by the method of the invention for making the comparison between a continuous value analogue signal and a continuous value digital signal having the features according to independent claim 1. Such objects are also achieved by the circuit architecture configured to carry out the aforesaid method of the invention, having the features according to claim 8.

Further features of the method and of the circuit architecture of the invention are described in the dependent claims.

The aforesaid objects, together with the advantages described below, will be noted during the description of certain preferred implementation embodiments of the invention, which are given by way of non-limiting indicative example, with reference to the accompanying drawings, where:

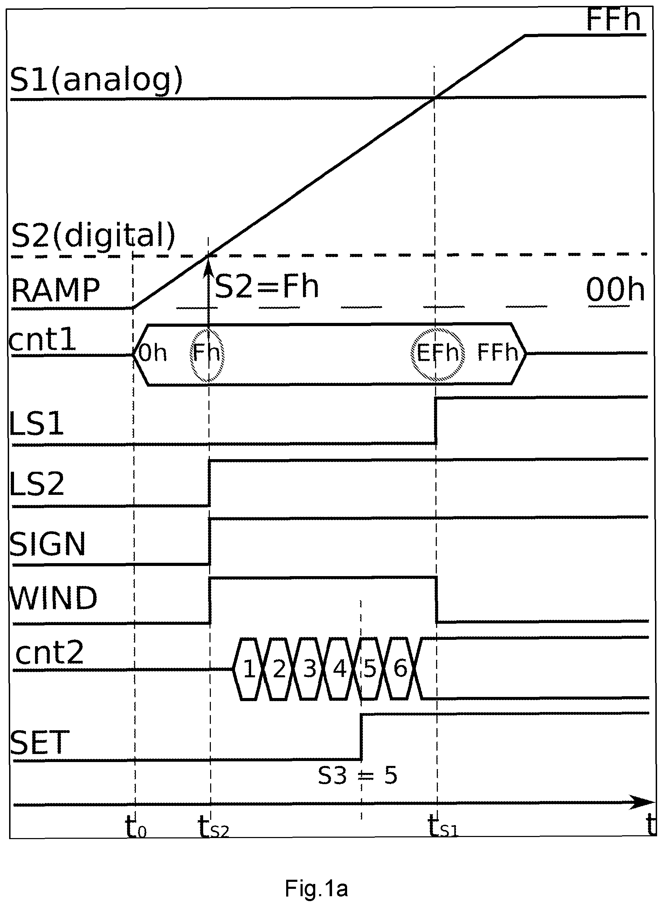

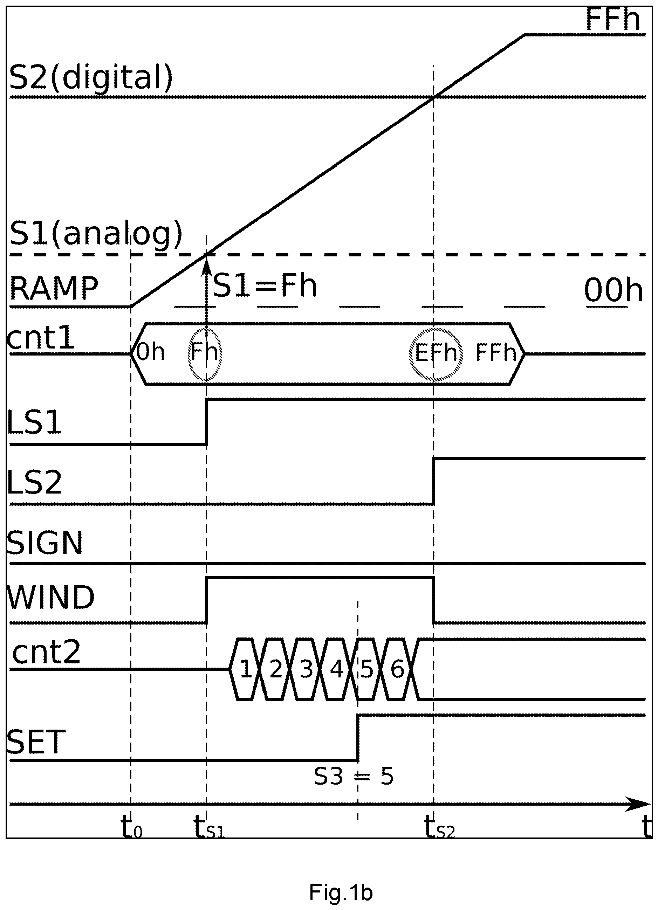

- figures 1a and 1b depict time diagrams of the signals involved in carrying out the method of the invention according to the preferred implementation embodiment, respectively in the case in which the analogue signal S1 has a greater value than the digital signal S2 and in the case in which the analogue signal S1 has a lesser value than the digital signal S2;

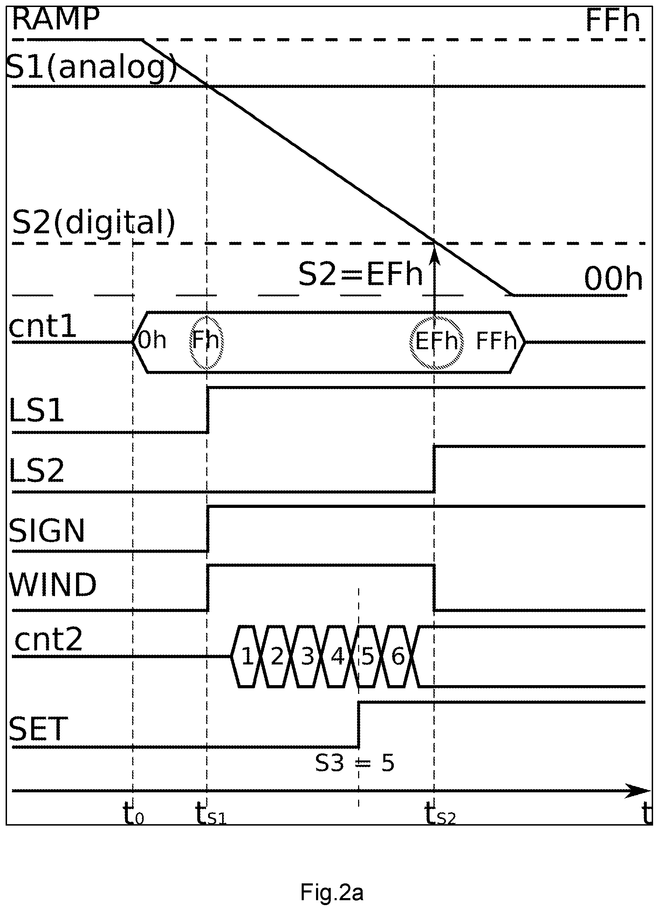

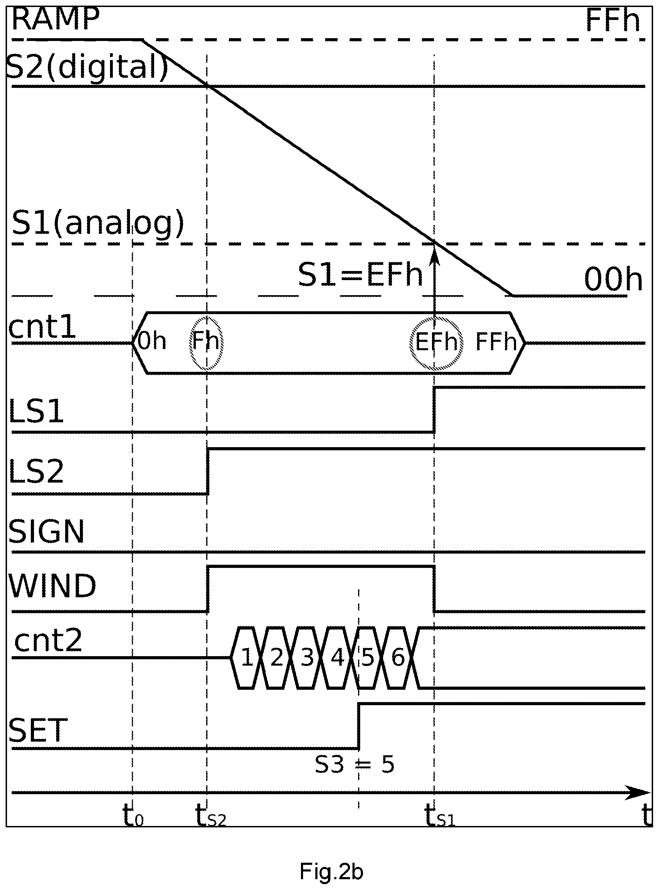

- figures 2a and 2b depict time diagrams of the signals involved in carrying out the method of the invention according to an alternative implementation embodiment, respectively in the case in which the analogue signal S1 has a greater value than the digital signal S2 and in the case in which the analogue signal S1 has a lesser value than the digital signal S2;

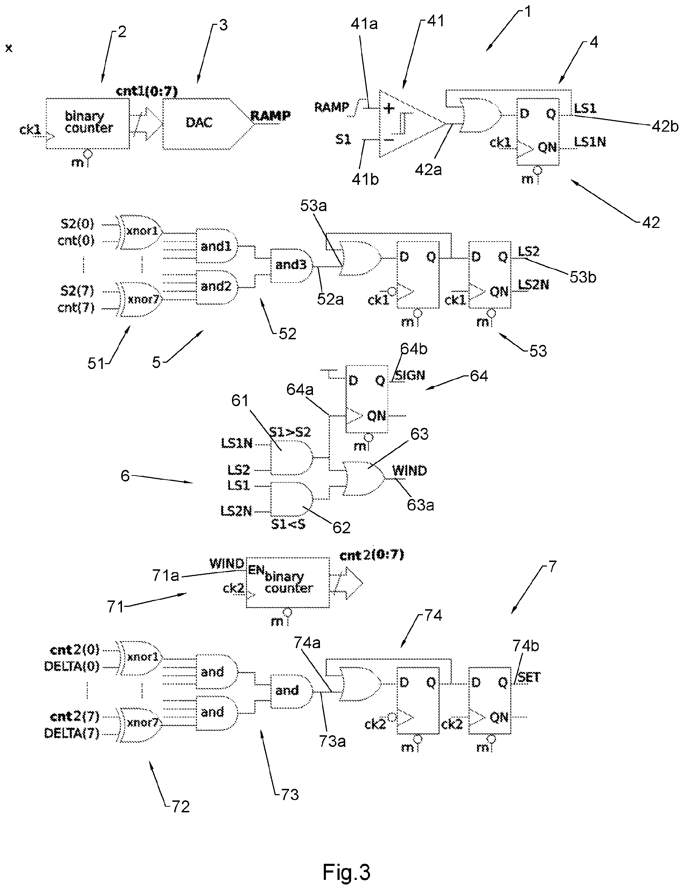

- figure 3 diagrammatically depicts the circuit architecture of the invention, configured to carry out the method of the invention.

To clarify the execution of the method of the invention, which is adapted to compare a continuous value analogue signal **S1** and a continuous value digital signal **S2,** certain time diagrams relative to the signals considered in the various execution steps of the method itself are introduced and taken into consideration below. In particular, the time diagrams in figures 1a and 1b depict the signals involved in carrying out the method of the invention according to a preferred implementation embodiment thereof, while the time diagrams in figures 2a and 2b depict the signals considered during the execution of the method of the invention according to an alternative implementation embodiment thereof.

Furthermore, it is to be noted that figures 1a and 2a hypothesize the execution of the method of the invention with the analogue signal **S1** having a greater value with respect to the value of the digital signal **S2.** Figures 1b and 2b instead hypothesize the opposite situation, that is in the case in which the analogue signal **S1** has a lesser value with respect to the value of the digital signal **S2.**

Again, for the aforesaid preferred implementation embodiment, as well as for the alternative implementation embodiment, the analogue signals considered are voltage signals. However, it is not excluded for the analogue signals to be current signals in further implementation embodiments alternative to the ones above.

Starting now to describe the execution of the method of the invention according to the preferred implementation embodiment, it provides defining a ramp analogue signal **RAMP** having linearly variable value over time. As noted in figures 1a and 1b, such ramp analogue signal **RAMP** in particular is of the type which increases linearly over time.

Such definition of the ramp analogue signal **RAMP** requires periodically varying, for each time interval belonging to first predetermined time intervals **ck1,** a first digital numerical value **cnt1** by a predetermined quantity, and also providing to convert such first digital numerical value **cnt1** into the aforesaid ramp analogue signal **RAMP** by means of a digital/analogue converter.

More specifically, according to the preferred implementation embodiment of the invention, the ramp analogue signal **RAMP** of the linearly increasing type is obtained by increasing the first digital numerical value **cnt1** - preferably initialized at the value "0" - by such predefined quantity, which usually is selected equal to one unit.

Alternatively, according to the alternative implementation embodiment in figures 2a and 2b, the ramp analogue signal **RAMP** is defined so that it is a linearly decreasing ramp analogue signal. Such a decreasing trend is obtained by decreasing the aforesaid first digital numerical value **cnt1** initialized at a predefined positive value, by such predefined quantity, which preferably is selected equal to one unit. Here too there is a need, for each first time interval **ck1,** to convert the first digital numerical value **cnt1** by means of the aforesaid digital/analogue converter in order to obtain such decreasing ramp analogue signal **RAMP.**

Whether or not according to the preferred implementation embodiment or according to the alternative implementation embodiment, the method of the invention also provides simultaneously comparing the value of the ramp analogue signal **RAMP** with the analogue signal **S1** and the first digital numerical value **cnt1** with the digital signal **S2** at each of such first predetermined time intervals **ck1.**

Such a comparison therefore allows the method of the invention to verify at which of the first predetermined time intervals **ck1** the value of the ramp analogue signal **RAMP** equals the analogue signal **S1** and at which of the same predetermined time intervals **ck1** the first digital numerical value **cnt1** equals the digital signal **S2.** Accordingly, the method of the invention is capable of temporally defining which of the aforesaid equalities occurs first and which occurs second, and is also capable of defining the time window **WIND** between the first equality and the second equality.

Considering now the four time diagrams introduced above, it is worth noting for figure 1a - which provides an increase of the first digital numerical value **cnt1** and accordingly, a linear increase of the ramp analogue signal **RAMP** - that the execution of the method of the invention allows identifying the equality of the digital signal **S2** with such first digital numerical value **cnt1** at a time interval **ck1** prior to the time interval **ck1** in which the equality occurs between the analogue signal **S1** and the ramp analogue signal **RAMP.** The exact opposite occurs in figure 1b, that is the execution of the method of the invention allows identifying the equality between the analogue signal **S1** and the ramp analogue signal **RAMP** before the equality between the digital signal **S2** with such first digital numerical value **cnt1.**

With regard to figure 2a which, as mentioned above, depicts the alternative implementation embodiment of the method of the invention with the first digital numerical value **cnt1** of decreasing type and accordingly the ramp analogue signal **RAMP** of increasing type, it is worth noting that the execution of the same method allows first identifying the equality between the analogue signal **S1** and the ramp analogue signal **RAMP** and then the equality between the digital signal **S2** with such first digital numerical value **cnt1.**

Finally, for the case shown in figure 2b, the execution of the method of the invention allows first identifying the equality of the digital signal **S2** with the first digital numerical value **cnt1** and then the equality between the analogue signal **S1** and the ramp analogue signal **RAMP.**

According to the preferred implementation embodiment of the method of the invention, the comparison operation at each of the first predetermined time intervals **ck1** of the value of the ramp analogue signal **RAMP** with the analogue signal **S1** consists in inputting the aforesaid two analogue signals into an analogue comparator, and it provides commuting, in output, a first output signal **LS1** from a first value to a second value at the time interval **ck1** in which the value of the ramp analogue signal **RAMP** equals the analogue signal **S1.** The method of the invention further provides keeping such first output signal **LS1** constant at the aforesaid second value following such commutation.

Note the trend of the signal **LS1** in figure 1a and in figure 1b for increased clarity.

As noted in figures 2a and 2b, also the alternative implementation embodiment provides carrying out the same comparison method and treating the first output signal **LS1** in the same way as the preferred implementation embodiment described above.

With regard to the comparison operation of the first digital numerical value **cnt1** with the digital signal **S2,** the method according to the preferred implementation embodiment of the invention provides comparing each bit representing the first digital numerical value **cnt1** with the bit in the same position representing the digital signal **S2,** at each of the predetermined time intervals **ck1.** Such comparison further provides commuting a second output signal **LS2** from a first value to a second value at the time interval **ck1** in which all the bits of the first digital numerical value **cnt1** equal the corresponding bits of the digital signal **S2,** and keeping the second output signal **LS2** constant at such second value following such commutation. Refer to the depiction of the signal **LS2** in figures 1a and 1b for increased clarity.

As noted in figures 2a and 2b, also the alternative implementation embodiment of the method of the invention provides carrying out the same comparison method and treating the second output signal **LS2** in the same way as that provided by the preferred implementation embodiment.

With regard to the step of defining the time order of the aforesaid equalities, it provides comparing the first output signal **LS1** and the second output signal **LS2** and establishing which of the two output signs **LS1** and **LS2** commutes first.

Moreover, the method of the invention provides defining a time window **WIND** between the moment in time **ck1** in which the first of the aforesaid commutations occurs and the moment in time in which the second commutation occurs.

As noted in figures 1a and 1b for the preferred implementation embodiment of the invention and in figures 2a and 2b for the alternative implementation embodiment, the method provides increasing, during the aforesaid time window **WIND,** a second digital numerical value **cnt2,** preferably initialized at "0" before the beginning of the same time window **WIND.** Such an increase in particular occurs within the aforesaid time window **WIND** for each time interval belonging to second predetermined time intervals **ck2.** The duration of each time interval belonging to the aforesaid second predetermined time intervals **ck2** could be equal to or less than the duration of each time interval belonging to the first predetermined time intervals **ck1.**

With regard to the meaning of the aforesaid second digital numerical value **cnt2,** it represents the deviation that exists between the analogue signal **S1** and the digital signal **S2.**

In particular, such second digital numerical value **cnt2** is increased during the time window **WIND** and at the closing of the latter the same second digital numerical value **cnt2** represents the final deviation value between the analogue signal **S1** and the digital signal **S2.**

Finally, the method of the invention provides the further step - always performed at each of the aforesaid second time intervals **ck2** - of comparing the second digital numerical value **cnt2** with a predetermined threshold value **DELTA** so as to verify if and when the same second digital numerical value **cnt2** equals the predetermined threshold **DELTA.**

More specifically, the comparison operation of the second digital numerical value **cnt2** with a predetermined threshold digital value **DELTA** at each of the second predetermined time intervals **ck2** according to the preferred implementation embodiment of the invention provides comparing each bit representing the second digital numerical value **cnt2** with the bit in the same position, which represents the predetermined threshold digital value **DELTA.** Moreover, the method of the invention provides commuting a third output signal **SET** from a first value to a second value at the time interval belonging to the second predetermined time intervals **ck2** in which all the bits of the second digital numerical value **cnt2** equal the corresponding bits of the predetermined threshold digital value **DELTA** and keeping the third output signal **SET** constant at the second value following such commutation.

Therefore, it is possible, with the method of the invention, to compare two signals **S1** and **S2** which are different in nature, in particular an analogue signal **S1** and a digital signal **S2.**

An implementation embodiment of circuit architecture **1** depicted diagrammatically in figure 3 is now introduced; it is configured to carry out the comparison method of the invention between a continuous value analogue signal **S1** and a continuous value digital signal **S2.**

In particular as noted in figure 3, such circuit architecture **1** comprises a first binary counter **2** configured to generate and periodically vary at first predetermined time intervals **ck1** of the aforesaid first digital numerical value **cnt1.**

Preferably, such first binary counter **2** uses one byte (8 bits) to define the aforesaid first digital numerical value **cnt1.**

The circuit architecture **1** also comprises a digital/analogue converter **3** operatively connected at the output of the first binary counter **2** so that the same digital/analogue converter **3** generates, in output, the ramp analogue signal **RAMP** having linearly variable value over time starting from such first digital numerical value **cnt1.**

Advantageously, such first binary counter **2** and the relative digital/analogue converter **3** could already be present and used for other logic functions performed in the chip in which the aforesaid circuit architecture **1** of the invention is implemented. In other words, the implementation of the circuit architecture **1** of the invention advantageously could take advantage of the common circuit components usually present and used for multiple functions, thus avoiding to make the latter specifically.

As observed in figure 3, the circuit architecture **1** also comprises a first logical comparison group **4** configured to make the comparison between the value of the ramp analogue signal **RAMP** with the analogue signal **S1** and to verify at which of the first predetermined time intervals **ck1** the analogue signals **S1** and **RAMP** equal one other.

According to the preferred implementation embodiment of the invention, the first logical comparison group **4** in particular comprises an analogue comparator **41** with a first input **41a** connected to the digital/analogue converter **3** to receive, in input, the ramp analogue signal **RAMP,** and with a second input **41b** configured to receive, in input, the analogue signal **S1.** A first electronic storage circuit **42** is operatively connected downstream of such analogue comparator **41.**

In particular, such first electronic storage circuit **42** is operatively connected with its input **42a** to the output **41c** of the analogue comparator **41.**

The first electronic storage circuit **42** according to the invention is configured to commute the first output signal **LS1** from a first value to a second value at the time interval **ck1** in which the analogue comparator **41** detects the equality between the value of the ramp analogue signal **RAMP** and the analogue signal **S1.** Moreover, such first electronic storage circuit **42** is configured to keep the first output signal **LS1** constant at the aforesaid second value following such commutation.

As noted in figure 3, the first electronic storage circuit **42** is provided with an output **42b** for making available the aforesaid first output signal **LS1.**

The circuit architecture **1** of the invention also comprises a second logical comparison group **5** configured to make the comparison between the first digital numerical value **cnt1** and the digital signal **S2,** and to verify at which of the first predetermined time intervals **ck1** the digital signals **S2** and **cnt1** equal one other.

In particular, the second logical comparison group **5** comprises a number of logic gates **51** of "XNOR" type equal to the number of bits with which the first digital numerical value **cnt1** and the digital signal **S2** are defined. According to the preferred embodiment of the circuit architecture **1** of the invention, there are eight of such logic gates **51** of "XNOR" type, like the number of bits with which the first digital numerical value **cnt1** and the digital signal **S2** are represented.

Each of the aforesaid "XNOR" logic gates **51** is configured to receive, in input, bits having same position as the first digital numerical value **cnt1** and the digital signal **S2.** Moreover, the totality of the "XNOR" logic gates **51** have their own outputs arranged at the input of a logical block **52** of "AND" type so as to obtain, at the output **52a** of such logical block **52** of "AND" type, a logical value "1" at the time interval **ck1** in which all the bits of the first digital numerical value **cnt1** equal the corresponding bits of the digital signal **S2.** Obviously, also such logical block **52** of "AND" type belongs to the second logical comparison group **5.**

Moreover, the same second logical comparison group **5** comprises a second electronic storage circuit **53** operatively connected with its input **53a** to the output **52a** of the logical block **52** of "AND" type.

The second electronic storage circuit **53** in particular is configured to commute the aforesaid second output signal **LS2** from a first value to a second value when the output **52a** of the logical block **52** of "AND" type is equal to "1". The same second electronic storage circuit **53** is configured to keep the second output signal **LS2** constant at such second value following the aforesaid commutation.

As noted in figure 3, the second electronic storage circuit **53** is provided with an output **53b** for making available the second output signal **LS2.**

The circuit architecture **1** of the invention comprises also a third logical comparison group **6** configured to temporally define which of the two aforesaid equalities occurs first and which occurs second, and to define, further, the aforesaid time window **WIND** between the first equality and the second equality.

In particular, according to the preferred implementation embodiment of the invention, the third logical comparison group **6** comprises a first logic gate **61** of "AND" type configured to receive, in input, the first output signal **LS1** and the negated of the second output signal **LS2N** and a second logic gate **62** of "AND" type configured to receive, in input, the negated of the same first output signal **LS1N** and the second output signal **LS2.**

Moreover, the third logical comparison group **6** comprises a logic gate **63** of "OR" type configured to receive, in input, the outputs of the first logic gate **61** of "AND" type and of the second logic gate **62** of "AND" type so as to obtain the logical value "1" on its output **63a** for a time period that defines the time window **WIND.**

Finally, the third logical comparison group **6** comprises a third storage circuit **64** operatively connected with its input **64a,** with the output exclusively of one between the first logic gate **61** of "AND" type and the second logic gate **62** of "AND" type. Such third storage circuit **64** is configured to commute its output **64b** from a first value to a second value and to keep such output constant to the aforesaid second value in the case in which it receives, in input, the logical value "1" from the logic gate of "AND" type to which it is connected.

In other words, the aforesaid third storage circuit **64** is configured to establish the sign of what was defined above as deviation between the analogue signal **S1** and the digital signal **S2.**

Finally, the circuit architecture **1** of the invention provides a fourth logical comparison group **7** comprising a second binary counter **71** configured to generate and periodically vary the aforesaid second digital numerical value **cnt2** at second predetermined time intervals **ck2** during the time window **WIND.**

Such fourth logical comparison group **7** is configured to compare the second digital numerical value **cnt2** with a predetermined threshold value **DELTA** at each of the aforesaid second time intervals **ck2** so as to verify if and when the same second digital numerical value **cnt2** equals the aforesaid predetermined threshold **DELTA.**

In detail, such second binary counter **71** is connected with its enabling input **71a** with the output **63a** of the logic gate **63** of "OR" type of the third logical comparison group **6** so that the same second binary counter **71** generates and periodically varies the value of the second digital numerical value **cnt2** exclusively during the aforesaid time window **WIND.**

Furthermore, with regard to the fourth logical comparison group 7, it comprises a number of logic gates **72** of "XNOR" type equal to the number of bits with which the second digital numerical value **cnt2** and the predetermined threshold value **DELTA** are defined.

Preferably, there are eight of the aforesaid logic gates **72** of "XNOR" type, as there are bits with which the second digital numerical value **cnt2** and the predetermined threshold value **DELTA** are defined.

Each of the "XNOR" logic gates **72** is configured to receive, in input, the bit of the same position as the second digital numerical value **cnt2** and as the predetermined threshold value **DELTA.** In their totality, such "XNOR" logic gates **72** have their outputs arranged in input at a logical block **73** of "AND" type so as to obtain, in output **73a** from the same logical block **73** of "AND" type, a logical value "1" at the time interval belonging to the aforesaid second predetermined time intervals **ck2** in which all the bits of the second digital numerical value **cnt2** equal the corresponding bits of the predetermined threshold value **DELTA.**

Clearly, the fourth logical comparison group **7** also comprises the aforesaid logical block **73** of "AND" type. Moreover, the fourth logical comparison group **7** comprises a fourth electronic storage circuit **74** operatively connected with its input **74a** to the output **73a** of the same logical block **73** of "AND" type. According to the invention, such fourth electronic storage circuit **74** is configured to commute the third output signal **SET** from a first value to a second value when the output **73a** of the logical block **73** of "AND" type is equal to "1". Furthermore, the fourth electronic storage circuit **74** is configured to keep such third output signal **SET** constant at the aforesaid second value following such commutation.

Finally, the fourth electronic storage circuit **74** according to the invention is provided with an output **74b** so as to make such third output signal **SET** available to the outside for further processing.

Based on what is said, therefore, the method of the invention and the circuit architecture of the invention achieve all the preset objects.

In particular, the object is achieved of defining a method and proposing a circuit architecture for making the comparison between a continuous value analogue signal and a continuous value digital signal which allow having a smaller voltage consumption with respect to a method and a relative comparison circuit of the purely analogue type.

The object is also achieved of defining a method and proposing a relative circuit architecture which allow ensuring increased flexibility in selecting and varying the value of the second signal - for example a threshold value - to be compared with the first signal, with respect to a method and a related comparison circuit of purely analogue type.

The further object is achieved of defining a method and proposing a circuit architecture which allow reducing the number of integrated electronic components required for the implementation thereof with respect to a method and a relative comparison circuit of purely digital type.

Accordingly, the object was also achieved of defining a method and proposing a circuit architecture which allow reducing the silicon area occupied with respect to a method and a relative comparison circuit of the purely digital type.

## Claims

1. A method for making the comparison between a continuous value analogue signal (S1) and a continuous value digital signal (S2), **characterized in that** it provides the following steps:
- defining a ramp analogue signal (RAMP) having linearly variable value over time, said definition providing to periodically vary, for each time interval belonging to first predetermined time intervals (ck1), a first digital numerical value (cnt1) by a predetermined quantity, and providing to convert said first digital numerical value (cnt1) into said ramp analogue signal (RAMP) by means of a digital/analogue converter;
- simultaneously comparing, at each of said first predetermined time intervals (ck1), the value of said ramp analogue signal (RAMP) with said analogue signal (S1) and said first digital numerical value (cnt1) with said digital signal (S2);
- verifying at which of said first predetermined time intervals (ck1) said value of said ramp analogue signal (RAMP) equals said analogue signal (S1) and at which of said predetermined time intervals (ck1) said first digital numerical value (cnt1) equals said digital signal (S2);
- temporally defining which of said equalities occurs first and which occurs second and also defining the time window (WIND) between said first equality and said second equality;
- increasing a second digital numerical value (cnt2) within said time window (WIND) for each time interval belonging to second predetermined time intervals (ck2), said second digital numerical value (cnt2) representing the deviation between said analogue signal (S1) and said digital signal (S2);
- comparing, at each of said second time intervals (ck2), said second digital numerical value (cnt2) with a predetermined threshold value (DELTA) so as to verify if and when said second digital numerical value (cnt2) equals said predetermined threshold (DELTA).

2. A method according to claim 1, **characterized in that** said step of defining said ramp analogue signal (RAMP) provides:
- increasing said first digital numerical value (cnt1) by said predefined quantity;
- converting said first digital numerical value (cnt1) so that said ramp analogue signal (RAMP) is a linearly increasing ramp analogue signal.

3. A method according to claim 1, **characterized in that** said step of defining said ramp analogue signal (RAMP) provides:
- decreasing said first digital numerical value (cnt1) starting from a predefined positive value of said predefined quantity;
- converting said first digital numerical value (cnt1) so that said ramp analogue signal (RAMP) is a linearly decreasing ramp analogue signal.

4. A method according to any one of the preceding claims, **characterized in that** said comparison operation at each of said first predetermined time intervals (ck1) of the value of said ramp analogue signal (RAMP) with said analogue signal (S1) provides inputting said analogue signals (S1, RAMP) at the input of an analogue comparator, said comparison further providing commuting, in output, a first output signal (LS1) from a first value to a second value at the time interval (ck1) in which the value of said ramp analogue signal (RAMP) equals said analogue signal (S1), and keeping said first output signal (LS1) constant at said second value following said commutation.

5. A method according to any one of the preceding claims, **characterized in that** said comparison operation at each of said first predetermined time intervals (ck1) of said first digital numerical value (cnt1) with said digital signal (S2) provides comparing each bit representing said first digital numerical value (cnt1) with the bit in the same position representing said digital signal (S2), said comparison further providing commuting a second output signal (LS2) from a first value to a second value at the time interval (ck1) in which all the bits of said first digital numerical value (cnt1) equal the corresponding bits of said digital signal (S1), and keeping said second output signal (LS2) constant at said second value following said commutation.

6. A method according to any one of the preceding claims, **characterized in that** said step of defining the time order of said equalities provides comparing said first output signal (LS1) and said second output signal (LS2) and establishing which of said output signals (LS1, LS2) commutes first.

7. A method according to any one of the preceding claims, **characterized in that** said comparison operation of said second digital numerical value (cnt2) with a predetermined threshold digital value (DELTA) at each of said second predetermined time intervals (ck2) provides:
- comparing each bit representing said second digital numerical value (cnt2) with the bit in the same position representing said predetermined threshold digital value (DELTA);
- commuting a third output signal (SET) from a first value to a second value at the time interval belonging to said second predetermined time intervals (ck2) in which all the bits of said second digital numerical value (cnt2) equal the corresponding bits of said predetermined threshold digital value (DELTA), and keeping said third output signal (SET) constant at said second value following said commutation.

8. Circuit architecture (1) configured to carry out the comparison method between a continuous value analogue signal (S1) and a continuous value digital signal (S2) according to any one of the preceding claims, **characterized in that** it comprises:
- a first binary counter (2) configured to generate and periodically vary at first predetermined time intervals (ck1) of said first digital numerical value (cnt1);
- a digital/analogue converter (3) operatively connected at the output of said first binary counter (2), said digital/analogue converter (3) being configured to generate, in output, said ramp analogue signal (RAMP) having linearly variable value over time;
- a first logical comparison group (4) configured to make the comparison between said value of said ramp analogue signal (RAMP) with said analogue signal (S1) and to verify at which of said first predetermined time intervals (ck1) said analogue signals (S1, RAMP) equal one other;
- a second logical comparison group (5) configured to make the comparison between said first digital numerical value (cnt1) and said digital signal (S2) and to verify at which of said first predetermined time intervals (ck1) said digital signals (S2, cnt1) equal one other;
- a third logical comparison group (6) configured to temporally define which of said equalities occurs first and which occurs second and to define said time window (WIND) between said first equality and said second equality;
- a fourth logical comparison group (7) comprising a second binary counter (71) configured to generate and periodically vary at second predetermined time intervals (ck2) of said second digital numerical value (cnt2) during said time window (WIND), said fourth logical comparison group (7) being configured to compare, at each of said second predetermined time intervals (ck2), said second digital numerical value (cnt2) with a predetermined threshold value (DELTA) so as to verify if and when said second digital numerical value (cnt2) equals said predetermined threshold (DELTA).

9. Circuit architecture (1) according to claim 8, **characterized in that** said first logical comparison group (4) comprises:
- an analogue comparator (41) with a first input (41a) connected to said digital/analogue converter (3) to receive, in input, said ramp analogue signal (RAMP), and with a second input (41b) configured to receive, in input, said analogue signal (S1);
- a first electronic storage circuit (42) operatively connected with its input (42a) to the output (41c) of said analogue comparator (41), said first electronic storage circuit (42) being configured to commute said first output signal (LS1) from a first value to a second value at the time interval (ck1) in which an analogue comparator (41) detects said equality between the value of said ramp analogue signal (RAMP) and said analogue signal (S1), and to keep said first output signal (LS1) constant at said second value following said commutation, said first electronic storage circuit (42) being provided with an output (42b) for said first output signal (LS1).

10. Circuit architecture according to any one of claims 8 or 9, **characterized in that** said second logical comparison group (5) comprises:
- a number of logic gates (51) of "XNOR" type equal to the number of bits with which said first digital numerical value (cnt1) and said digital signal (S2) are defined, each of said "XNOR" logic gates (51) being configured to receive, in input, bits having same position as said first digital numerical value (cnt1) and as said digital signal (S2), the totality of said "XNOR" logic gates (51) having their own outputs arranged at the input of a logical block (52) of "AND" type so as to obtain, in output (52a) from said logical block (52) of "AND" type, a logical value "1" at the time interval (ck1) in which all the bits of said first digital numerical value (cnt1) equal the corresponding bits of said digital signal (S2);
- said logical block (52) of "AND" type;
- a second electronic storage circuit (53) operatively connected with its input (53a) to the output (52a) of said logical block (52) of "AND" type, said second electronic storage circuit (53) being configured to commute said second output signal (LS2) from a first value to a second value when said output (52a) of said logical block (52) of "AND" type is equal to "1", and to keep said second output signal (LS2) constant at said second value following said commutation, said second electronic storage circuit (53) being provided with an output (53b) for said second output signal (LS2).

11. Circuit architecture according to any one of claims from 8 to 10, **characterized in that** said third logical comparison group (6) comprises:
- a first logic gate (61) of "AND" type configured to receive, in input, said first output signal (LS1) and the negated of said second output signal (LS2N);
- a second logic gate (62) of "AND" type configured to receive, in input, the negated of said first output signal (LS1N) and said second output signal (LS2);
- a logic gate (63) of "OR" type configured to receive, in input, the outputs of said first logic gate (61) of "AND" type and of said second logic gate (62) of "AND" type so as to obtain the logical value "1" for a time period that defines said time window (WIND) in output (63a), from said logic gate (63) of "OR" type;
- a third storage circuit (64) operatively connected, with its input (64a), with the output exclusively of one between said first logic gate (61) of "AND" type and said second logic gate (62) of "AND" type, said third storage circuit (64) being configured to commute its output (64b) from a first value to a second value and to keep said output constant at said second value if said input receives, in input, the logical value "1" from the logic gate of "AND" type to which it is connected.

12. Circuit architecture (1) according to claim 11, **characterized in that** said second binary counter (71) is connected with its enabling input (71a), with said output (63a) of said logic gate (63) of "OR" type of said third logical comparison group (6) so as to generate and periodically vary said second digital numerical value (cnt2) during said time window (WIND).

13. Circuit architecture (1) according to any one of the preceding claims, **characterized in that** said fourth logical comparison group (7) comprises:
- a number of logic gates (72) of "XNOR" type equal to the number of bits with which said second digital numerical value (cnt2) and said predetermined threshold value (DELTA) are defined, each of said "XNOR" logic gates (72) being configured to receive, in input, bits having same position as said second digital numerical value (cnt2) and as said predetermined threshold value (DELTA), the totality of said "XNOR" logic gates (72) having their own outputs arranged at the input of a logical block (73) of "AND" type so as to obtain, in output (73a) from said logical block (73) of "AND" type, a logical value "1" at the time interval of said second time intervals (ck2) in which all the bits of said second digital numerical value (cnt2) equal the corresponding bits of said predetermined threshold value (DELTA);
- said logical block (73) of "AND" type;
- a fourth electronic storage circuit (74) operatively connected with its input (74a) to the output (73a) of said logical block (73) of "AND" type, said fourth electronic storage circuit (74) being configured to commute said third output signal (SET) from a first value to a second value when said output (73a) of said logical block (73) of "AND" type is equal to "1", and to keep said third output signal (SET) constant at said second value following said commutation, said fourth electronic storage circuit (74) being provided with an output (74b) for said third output signal (SET).

## Patentansprüche

1. Verfahren, um einen Vergleich zwischen einem Analogsignal (S1) mit kontinuierlichem Wert und einem Digitalsignal (S2) mit kontinuierlichem Wert anzustellen, **dadurch gekennzeichnet, dass** es folgende Schritte vorsieht:
- Definieren eines analogen Rampensignals (RAMP) aufweisend einen über die Zeit linear variablen Wert, wobei die Definition vorsieht, für jedes Zeitintervall, das zu den ersten vorbestimmten Zeitintervallen (ck1) gehört, einen ersten digitalen numerischen Wert (cnt1) um eine vorbestimmte Menge periodisch zu variieren; sowie vorsieht, den ersten digitalen numerischen Wert (cnt1) mittels eines Digital/Analog-Wandlers in das analoge Rampensignal (RAMP) umzuwandeln;
- gleichzeitiges Vergleichen, in jedem der ersten vorbestimmten Zeitintervalle (ck1), des Wertes des analogen Rampensignals (RAMP) mit dem Analogsignal (S1) und des ersten digitalen numerischen Wertes (cnt1) mit dem Digitalsignal (S2);
- Überprüfen, in welchem der ersten vorbestimmten Zeitintervalle (ck1) der Wert des analogen Rampensignals (RAMP) dem Analogsignal (S1) gleich ist, und in welchem der vorbestimmten Zeitintervalle (ck1) der erste digitale numerische Wert (cnt1) dem Digitalsignal (S2) gleich ist;
- zeitlich definieren, welche der Gleichungen als erste auftritt und welche als zweite auftritt, und auch das Zeitfenster (WIND) zwischen der ersten Gleichung und der zweiten Gleichung definieren;
- Erhöhen eines zweiten digitalen numerischen Wertes (cnt2) innerhalb des Zeitfensters (WIND) für jedes Zeitintervall, das zu den zweiten vorbestimmten Zeitintervallen (ck2) gehört, wobei der zweite digitale numerische Wert (cnt2) die Abweichung zwischen dem Analogsignal (S1) und dem Digitalsignal (S2) darstellt;
- Vergleichen, in jedem der zweiten Zeitintervalle (ck2), des zweiten digitalen numerischen Wertes (cnt2) mit einem vorbestimmten Schwellenwert (DELTA), um zu überprüfen, ob und wann der zweite digitale numerische Wert (cnt2) dem vorbestimmten Schwellenwert (DELTA) gleich ist.

2. Verfahren nach Anspruch 1, **dadurch gekennzeichnet, dass** der Schritt des Definierens des analogen Rampensignals (RAMP) Folgendes vorsieht:
- Erhöhen des ersten digitalen numerischen Wertes (cnt1) um die vordefinierte Menge;
- Umwandeln des ersten digitalen numerischen Wertes (cnt1), so dass das analoge Rampensignal (RAMP) ein sich linear erhöhendes analoges Rampensignal ist.

3. Verfahren nach Anspruch 1, **dadurch gekennzeichnet, dass** der Schritt des Definierens des analogen Rampensignals (RAMP) Folgendes vorsieht:
- Verringern des ersten digitalen numerischen Wertes (cnt1) ausgehend von einem vordefinierten positiven Wert der vordefinierten Menge;
- Umwandeln des ersten digitalen numerischen Wertes (cnt1), so dass das analoge Rampensignal (RAMP) ein sich linear verringerndes analoges Rampensignal ist.

4. Verfahren nach irgendeinem der vorhergehenden Ansprüche, **dadurch gekennzeichnet, dass** die Vergleichsoperation in jedem der ersten vorbestimmten Zeitintervalle (ck1) des Wertes des analogen Rampensignals (RAMP) mit dem Analogsignal (S1), die Eingabe der Analogsignale (S1, RAMP) am Eingang eines analogen Komparators vorsieht, wobei der Vergleich ferner das Umschalten, am Ausgang, eines ersten Ausgangssignals (LS1) von einem ersten Wert auf einen zweiten Wert in dem Zeitintervall (ck1) vorsieht, in dem der Wert des analogen Rampensignals (RAMP) dem Analogsignal (S1) gleich ist, und wobei das erste Ausgangssignal (LS1) auf dem zweiten Wert nach dem Umschalten konstant gehalten wird.

5. Verfahren nach irgendeinem der vorhergehenden Ansprüche, **dadurch gekennzeichnet, dass** die Vergleichsoperation in jedem der ersten vorbestimmten Zeitintervalle (ck1) des ersten digitalen numerischen Wertes (cnt1) mit dem Digitalsignal (S2) einen Vergleich jedes den ersten digitalen numerischen Wert (cnt1) darstellenden Bits mit dem Bit in derselben das Digitalsignal (S2) darstellenden Position vorsieht, wobei der Vergleich ferner das Umschalten eines zweiten Ausgangssignals (LS2) von einem ersten Wert auf einen zweiten Wert im Zeitintervall (ck1) vorsieht, in dem alle Bits des ersten digitalen numerischen Wertes (cnt1) den entsprechenden Bits des Digitalsignals (S1) gleich sind, und das zweite Ausgangssignal (LS2) auf dem zweiten Wert nach dem Umschalten konstant gehalten wird.

6. Verfahren nach irgendeinem der vorhergehenden Ansprüche, **dadurch gekennzeichnet, dass** der Schritt des Bestimmens der zeitlichen Reihenfolge der Gleichungen, das Vergleichen des ersten Ausgangssignals (LS1) und des zweiten Ausgangssignals (LS2) und das Festlegen, welches der Ausgangssignale (LS1, LS2) zuerst umgeschaltet wird, vorsieht.

7. Verfahren nach irgendeinem der vorhergehenden Ansprüche, **dadurch gekennzeichnet, dass** die Vergleichsoperation des zweiten digitalen numerischen Wertes (cnt2) mit einem vorbestimmten digitalen Schwellenwert (DELTA) in jedem der zweiten vorbestimmten Zeitintervalle (ck2), Folgendes vorsieht:
- Vergleichen jedes den zweiten digitalen numerischen Wert (cnt2) darstellenden Bits mit dem Bit in derselben den vorbestimmten digitalen Schwellenwert (DELTA) darstellenden Position;
- Umschalten eines dritten Ausgangssignals (SET) von einem ersten Wert auf einen zweiten Wert in dem Zeitintervall, das zu den zweiten vorbestimmten Zeitintervallen (ck2) gehört, in denen alle Bits des zweiten digitalen numerischen Wertes (cnt2) den entsprechenden Bits des vorbestimmten digitalen Schwellenwerts (DELTA) gleich sind; und das dritte Ausgangssignal (SET) auf dem zweiten Wert nach dem Umschalten konstant halten.

8. Schaltungsarchitektur (1), die konfiguriert ist, um das Vergleichsverfahren zwischen einem Analogsignal (S1) mit kontinuierlichem Wert und einem Digitalsignal (S2) mit kontinuierlichem Wert nach irgendeinem der vorhergehenden Ansprüche durchzuführen, **dadurch gekennzeichnet, dass** sie Folgendes umfasst:
- einen ersten Binärzähler (2), der konfiguriert ist, den ersten digitalen numerischen Wert (cnt1) in ersten vorbestimmten Zeitintervallen (ck1) zu erzeugen und periodisch zu variieren;
- einen Digital/Analog-Wandler (3), der am Ausgang des ersten Binärzählers (2) betriebsmäßig verbunden ist, wobei der Digital/Analog-Wandler (3) konfiguriert ist, um am Ausgang das analoge Rampensignal (RAMP) zu erzeugen, das einen über die Zeit linear variablen Wert aufweist;
- eine erste logische Vergleichsgruppe (4), die konfiguriert ist, um den Vergleich zwischen dem Wert des analogen Rampensignals (RAMP) und dem Analogsignal (S1) durchzuführen, und um zu überprüfen, in welchem der ersten vorbestimmten Zeitintervalle (ck1) die Analogsignale (S1, RAMP) einander gleichen;
- eine zweite logische Vergleichsgruppe (5), die konfiguriert ist, um den Vergleich zwischen dem ersten digitalen numerischen Wert (cnt1) und dem Digitalsignal (S2) durchzuführen, und um zu überprüfen, in welchem der ersten vorbestimmten Zeitintervalle (ck1) die Digitalsignale (S2, cnt1) einander gleichen;
- eine dritte logische Vergleichsgruppe (6), die konfiguriert ist, um zeitlich zu definieren, welche der Gleichungen als erste auftritt und welche als zweite auftritt, und um das Zeitfenster (WIND) zwischen der ersten Gleichung und der zweiten Gleichung zu definieren;
- eine vierte logische Vergleichsgruppe (7), umfassend einen zweiten Binärzähler (71), der konfiguriert ist, den zweiten digitalen numerischen Wert (cnt2) in zweiten vorbestimmten Zeitintervallen (ck2) während des Zeitfensters (WIND) zu erzeugen und periodisch zu variieren, wobei die vierte logische Vergleichsgruppe (7) konfiguriert ist, um in jedem der zweiten vorbestimmten Zeitintervalle (ck2), den zweiten digitalen numerischen Wert (cnt2) mit einem vorbestimmten Schwellenwert (DELTA) zu vergleichen, um zu überprüfen, ob und wann der zweite digitale numerische Wert (cnt2) dem vorbestimmten Schwellenwert (DELTA) gleich ist.

9. Schaltungsarchitektur (1) nach Anspruch 8, **dadurch gekennzeichnet, dass** die erste logische Vergleichsgruppe (4) Folgendes umfasst:
- einen analogen Komparator (41) mit einem ersten Eingang (41a), der mit dem Digital/Analog-Wandler (3) verbunden ist, um das analoge Rampensignal (RAMP) am Eingang zu empfangen, und mit einem zweiten Eingang (41b), der konfiguriert ist, um das Analogsignal (S1) am Eingang zu empfangen;
- eine erste elektronische Speicherschaltung (42), die mit ihrem Eingang (42a) betriebsmäßig mit dem Ausgang (41c) des analogen Komparators (41) verbunden ist, wobei die erste elektronische Speicherschaltung (42) konfiguriert ist, um das erste Ausgangssignal (LS1) von einem ersten Wert auf einen zweiten Wert in dem Zeitintervall (ck1) umzuwandeln, in dem ein analoger Komparator (41) die Gleichung zwischen dem Wert des analogen Rampensignals (RAMP) und des Analogsignals (S1) erfasst; und um das erste Ausgangssignal (LS1) auf dem zweiten Wert nach dem Umschalten konstant zu halten, wobei die erste elektronische Speicherschaltung (42) mit einem Ausgang (42b) für das erste Ausgangssignal (LS1) versehen ist.

10. Schaltungsarchitektur nach irgendeinem der Ansprüche 8 oder 9, **dadurch gekennzeichnet, dass** die zweite logische Vergleichsgruppe (5) Folgendes umfasst:
- eine Anzahl von Logikgattern (51) des Typs "XNOR", die gleich der Anzahl von Bits ist, mit denen der erste digitale numerische Wert (cnt1) und das Digitalsignal (S2) definiert sind, wobei jedes der "XNOR"-Logikgatter (51) konfiguriert ist, um, am Eingang, Bits zu empfangen, die dieselbe Position wie der erste digitale numerische Wert (cnt1) und wie das Digitalsignal (S2) aufweisen, wobei die Gesamtheit der "XNOR"-Logikgatter (51) eigene Ausgänge aufweisen, die an dem Eingang eines logischen Blocks (52) des Typs "AND" angeordnet sind, um am Ausgang (52a) einen logischen Wert "1" von dem logischen Block (52) des Typs "AND" im Zeitintervall (ck1) zu erhalten, in dem alle Bits des ersten digitalen numerischen Wertes (cnt1) den entsprechenden Bits des Digitalsignals (S2) gleich sind;
- den logischen Block (52) des Typs "AND";
- eine zweite elektronische Speicherschaltung (53), die mit ihrem Eingang (53a) betriebsmäßig mit dem Ausgang (52a) des logischen Blocks (52) des Typs "AND" verbunden ist, wobei die zweite elektronische Speicherschaltung (53) konfiguriert ist, um das zweite Ausgangssignal (LS2) von einem ersten Wert auf einen zweiten Wert umzuwandeln, wenn der Ausgang (52a) des logischen Blocks (52) des Typs "AND" gleich "1" ist; und um das zweite Ausgangssignal (LS2) auf dem zweiten Wert nach dem Umschalten konstant zu halten, wobei die zweite elektronische Speicherschaltung (53) mit einem Ausgang (53b) für das zweite Ausgangssignal (LS2) versehen ist.

11. Schaltungsarchitektur nach irgendeinem der Ansprüche von 8 bis 10, **dadurch gekennzeichnet, dass** die dritte logische Vergleichsgruppe (6) Folgendes umfasst:
- ein erstes Logikgatter (61) des Typs "AND", das konfiguriert ist, um, am Eingang, das erste Ausgangssignal (LS1) und das Negativ des zweiten Ausgangssignals (LS2N) zu empfangen;
- ein zweites Logikgatter (62) des Typs "AND", das konfiguriert ist, um, am Eingang, das Negativ des ersten Ausgangssignals (LS1N) und das zweite Ausgangssignal (LS2) zu empfangen;
- ein Logikgatter (63) des Typs "OR", das konfiguriert ist, um, am Eingang, die Ausgänge des ersten Logikgatters (61) des Typs "AND" und des zweiten Logikgatters (62) des Typs "AND" zu empfangen, um somit den logischen Wert "1" für einen Zeitraum, der das Zeitfenster (WIND) am Ausgang (63a) definiert, von dem Logikgatter (63) des Typs "OR" zu erhalten;
- eine dritte Speicherschaltung (64), die mit ihrem Eingang (64a) betriebsmäßig mit dem Ausgang ausschließlich des einen ersten Logikgatters (61) des Typs "AND" oder des zweiten Logikgatters (62) des Typs "AND" verbunden ist, wobei die dritte Speicherschaltung (64) konfiguriert ist, um ihren Ausgang (64b) von einem ersten Wert auf einen zweiten Wert umzuwandeln, und den Ausgang auf dem zweiten Wert konstant zu halten, wenn der Eingang, den logischen Wert "1" vom Logikgatter des Typs "AND", mit dem es verbunden ist, am Eingang empfängt.

12. Schaltungsarchitektur (1) nach Anspruch 11, **dadurch gekennzeichnet, dass** der zweite Binärzähler (71) mit seinem Freigabeeingang (71a) mit dem Ausgang (63a) des Logikgatters (63) des Typs "OR" der dritten logischen Vergleichsgruppe (6) verbunden ist, um den zweiten digitalen numerischen Wert (cnt2) während des Zeitfensters (WIND) zu erzeugen und periodisch zu variieren.

13. Schaltungsarchitektur (1) nach irgendeinem der vorhergehenden Ansprüche, **dadurch gekennzeichnet, dass** die vierte logische Vergleichsgruppe (7) Folgendes umfasst:
- eine Anzahl von Logikgattern (72) des Typs "XNOR", die gleich der Anzahl von Bits ist, mit denen der zweite digitale numerische Wert (cnt2) und der vorbestimmte Schwellenwert (DELTA) definiert sind, wobei jedes der "XNOR"-Logikgatter (72) konfiguriert ist, um, am Eingang, Bits zu empfangen, die dieselbe Position wie der zweite digitale numerische Wert (cnt2) und wie der vorbestimmte Schwellenwert (DELTA) aufweisen, wobei die Gesamtheit der "XNOR"-Logikgatter (72) eigene Ausgänge aufweisen, die an dem Eingang eines logischen Blocks (73) des Typs "AND" angeordnet sind, um, am Ausgang (73a), einen logischen Wert "1" von dem logischen Block (73) des Typs "AND" im Zeitintervall der zweiten Zeitintervalle (ck2) zu erhalten, in dem alle Bits des zweiten digitalen numerischen Wertes (cnt2) den entsprechenden Bits des vorbestimmten Schwellenwerts (DELTA) gleich sind;
- den logischen Block (73) des Typs "AND";
- eine vierte elektronische Speicherschaltung (74), die mit ihrem Eingang (74a) betriebsmäßig mit dem Ausgang (73a) des logischen Blocks (73) des Typs "AND" verbunden ist, wobei die vierte elektronische Speicherschaltung (74) konfiguriert ist, um das dritte Ausgangssignal (SET) von einem ersten Wert auf einen zweiten Wert umzuwandeln, wenn der Ausgang (73a) des logischen Blocks (73) des Typs "AND" gleich "1" ist, und um das dritte Ausgangssignal (SET) auf dem zweiten Wert nach dem Umschalten konstant zu halten, wobei die vierte elektronische Speicherschaltung (74) mit einem Ausgang (74b) für das dritte Ausgangssignal (SET) versehen ist.

## Revendications

1. Procédé pour faire la comparaison entre un signal analogique à valeur continue (S1) et un signal numérique à valeur continue (S2), **caractérisé en ce qu'**il prévoit les étapes suivantes:
- définir un signal analogique de rampe (RAMP) ayant une valeur variable linéairement dans le temps, ladite définition prévoyant de varier périodiquement, pour chaque intervalle de temps appartenant à des premiers intervalles de temps (ck1) prédéterminés, une première valeur numérique chiffrée (cnt1) d'une quantité prédéterminée, et prévoyant de convertir ladite première valeur numérique chiffrée (cnt1) en ledit signal analogique de rampe (RAMP) au moyen d'un convertisseur numérique/ analogique;
- comparer simultanément, au niveau de chacun desdits premiers intervalles de temps (ck1) prédéterminés, la valeur dudit signal analogique de rampe (RAMP) avec ledit signal analogique (S1) et ladite première valeur numérique chiffrée (cnt1) avec ledit signal numérique (S2);
- vérifier au niveau duquel desdits premiers intervalles de temps (ck1) prédéterminés ladite valeur dudit signal analogique de rampe (RAMP) est égale audit signal analogique (S1) et au niveau duquel desdits intervalles de temps (ck1) prédéterminés ladite première valeur numérique chiffrée (cnt1) est égale audit signal numérique (S2);
- définir temporairement laquelle desdites égalités se produit en premier et laquelle se produit en deuxième et définir également la plage temporelle (WIND) entre ladite première égalité et ladite deuxième égalité;
- augmenter une deuxième valeur numérique chiffrée (cnt2) à l'intérieur de ladite plage temporelle (WIND) pour chaque intervalle de temps appartenant à des deuxièmes intervalles de temps (ck2) prédéterminés, ladite deuxième valeur numérique chiffrée (cnt2) représentant la déviation entre ledit signal analogique (S1) et ledit signal numérique (S2);
- comparer, au niveau de chacun desdits deuxièmes intervalles de temps (ck2), ladite deuxième valeur numérique chiffrée (cnt2) avec une valeur de seuil (DELTA) prédéterminée de façon à vérifier si et quand ladite deuxième valeur numérique chiffrée (cnt2) est égale audit seuil (DELTA) prédéterminé.

2. Procédé selon la revendication 1, **caractérisé en ce que** ladite étape de définir ledit signal analogique de rampe (RAMP) prévoit:
- d'augmenter ladite première valeur numérique chiffré (cnt1) de ladite quantité prédéfinie;
- de convertir ladite première valeur numérique chiffrée (cnt1) de sorte que ledit signal analogique de rampe (RAMP) soit un signal analogique de rampe augmentant linéairement.

3. Procédé selon la revendication 1, **caractérisé en ce que** ladite étape de définir ledit signal analogique de rampe (RAMP) prévoit:
- de diminuer ladite première valeur numérique chiffrée (cnt1) à partir d'une valeur positive prédéfinie de ladite quantité prédéfinie;
- de convertir ladite première valeur numérique chiffrée (cnt1) de sorte que ledit signal analogique de rampe (RAMP) soit un signal analogique de rampe diminuant linéairement.

4. Procédé selon l'une quelconque des revendications précédentes, **caractérisé en ce que** ladite opération de comparaison au niveau de chacun desdits premiers intervalles de temps (ck1) prédéterminés de la valeur dudit signal analogique de rampe (RAMP) avec ledit signal analogique (S1) prévoit d'introduire lesdits signaux analogiques (S1, RAMP) à l'entrée d'un comparateur analogique, ladite comparaison prévoyant en outre de commuter, à la sortie, un premier signal de sortie (LS1) d'une première valeur à une deuxième valeur au niveau de l'intervalle de temps (ck1) dans lequel la valeur dudit signal analogique de rampe (RAMP) est égal audit signal analogique (S1), et de maintenir ledit premier signal de sortie (LS1) constant à ladite deuxième valeur suite à ladite commutation.

5. Procédé selon l'une quelconque des revendications précédentes, **caractérisé en ce que** ladite opération de comparaison au niveau de chacun desdits premiers intervalles de temps (ck1) prédéterminés de ladite première valeur numérique chiffrée (cnt1) avec ledit signal numérique (S2) prévoit de comparer chaque bit représentant ladite première valeur numérique chiffrée (cnt1) avec le bit dans la même position représentant ledit signal numérique (S2), ladite comparaison prévoyant en outre de commuter un deuxième signal de sortie (LS2) d'une première valeur à une deuxième valeur au niveau de l'intervalle de temps (ck1) dans lequel tous les bits de ladite première valeur numérique chiffrée (cnt1) sont égaux aux bits correspondants dudit signal numérique (S1), et de maintenir ledit deuxième signal de sortie (LS2) constant à ladite deuxième valeur suite à ladite commutation.

6. Procédé selon l'une quelconque des revendications précédentes, **caractérisé en ce que** ladite étape de définir l'ordre temporel desdites égalités prévoit de comparer ledit premier signal de sortie (LS1) et ledit deuxième signal de sortie (LS2) et d'établir lequel desdits signaux de sortie (LS1, LS2) commute en premier.

7. Procédé selon l'une quelconque des revendications précédentes, **caractérisé en ce que** ladite opération de comparaison de ladite deuxième valeur numérique chiffrée (cnt2) avec une valeur numérique de seuil (DELTA) prédéterminée au niveau de chacun desdits deuxièmes intervalles de temps (ck2) prédéterminés prévoit:
- de comparer chaque bit représentant ladite deuxième valeur numérique chiffrée (cnt2) avec le bit dans la même position représentant ladite valeur numérique de seuil (DELTA) prédéterminée;
- de commuter un troisième signal de sortie (SET) d'une première valeur à une deuxième valeur au niveau de l'intervalle de temps appartenant auxdits deuxièmes intervalles de temps (ck2) prédéterminés dans lequel tous les bits de ladite deuxième valeur numérique chiffrée (cnt2) sont égaux aux bits correspondants de ladite valeur numérique de seuil (DELTA) prédéterminée, et de maintenir ledit troisième signal de sortie (SET) constant à ladite deuxième valeur suite à ladite commutation.

8. Architecture de circuit (1) configurée pour réaliser le procédé de comparaison entre un signal analogique à valeur continue (S1) et un signal numérique à valeur continue (S2) selon l'une quelconque des revendications précédentes, **caractérisée en ce qu'**elle comprend:
- un premier compteur binaire (2) configuré pour générer et varier périodiquement au niveau de premiers intervalles de temps (ck1) prédéterminés de ladite première valeur numérique chiffrée (cnt1);
- un convertisseur numérique/analogique (3) connecté opérationnellement à la sortie dudit premier compteur binaire (2), ledit convertisseur numérique/ analogique (3) étant configuré pour générer, à la sortie, ledit signal analogique de rampe (RAMP) ayant une valeur variable linéairement dans le temps;
- un premier groupe de comparaison logique (4) configuré pour faire la comparaison entre ladite valeur dudit signal analogique de rampe (RAMP) avec ledit signal analogique (S1) et pour vérifier au niveau duquel desdits premiers intervalles de temps (ck1) prédéterminés lesdits signaux analogiques (S1, RAMP) sont égaux entre eux;
- un deuxième groupe de comparaison logique (5) configuré pour faire la comparaison entre ladite première valeur numérique chiffrée (cnt1) et ledit signal numérique (S2) et pour vérifier au niveau duquel desdits premiers intervalles de temps (ck1) prédéterminés lesdits signaux numériques (S2, cnt1) sont égaux entre eux;
- un troisième groupe de comparaison logique (6) configuré pour définir temporairement laquelle desdites égalités se produit en premier et laquelle se produit en deuxième et pour définir ladite plage temporelle (WIND) entre ladite première égalité et ladite deuxième égalité;
- un quatrième groupe de comparaison logique (7) comprenant un deuxième compteur binaire (71) configuré pour générer et varier périodiquement au niveau de deuxièmes intervalles de temps (ck2) prédéterminés de ladite deuxième valeur numérique chiffrée (cnt2) pendant ladite plage temporelle (WIND), ledit quatrième groupe de comparaison logique (7) étant configuré pour comparer, au niveau de chacun desdits deuxièmes intervalles de temps (ck2) prédéterminés, ladite deuxième valeur numérique chiffrée (cnt2) avec une valeur de seuil (DELTA) prédéterminée de façon à vérifier si et quand ladite deuxième valeur numérique chiffrée (cnt2) est égale audit seuil (DELTA) prédéterminé.

9. Architecture de circuit (1) selon la revendication 8, **caractérisée en ce que** ledit premier groupe de comparaison logique (4) comprend:
- un comparateur analogique (41) avec une première entrée (41a) connectée audit convertisseur numérique/analogique (3) pour recevoir, en entrée, ledit signal analogique de rampe (RAMP), et avec une deuxième entrée (41b) configurée pour recevoir, en entrée, ledit signal analogique (S1);
- un premier circuit électronique de stockage (42) connecté opérationnellement avec son entrée (42a) à la sortie (41c) dudit comparateur analogique (41), ledit premier circuit électronique de stockage (42) étant configuré pour commuter ledit premier signal de sortie (LS1) d'une première valeur à une deuxième valeur au niveau de l'intervalle de temps (ck1) dans lequel un comparateur analogique (41) détecte ladite égalité entre la valeur dudit signal analogique de rampe (RAMP) et ledit signal analogique (S1), et pour maintenir ledit premier signal de sortie (LS1) constant à ladite deuxième valeur suite à ladite commutation, ledit premier circuit électronique de stockage (42) étant pourvu d'une sortie (42b) pour ledit premier signal de sortie (LS1).

10. Architecture de circuit selon l'une quelconque des revendications 8 ou 9, **caractérisée en ce que** ledit deuxième groupe de comparaison logique (5) comprend:
- un nombre de portes logiques (51) de type "XNOR" égal au nombre de bits avec lesquels ladite première valeur numérique chiffrée (cnt1) et ledit signal numérique (S2) sont définis, chacune desdites portes logiques (51) "XNOR" étant configurée pour recevoir, en entrée, des bits ayant la même position que ladite première valeur numérique chiffrée (cnt1) et que ledit signal numérique (S2), la totalité desdites portes logiques (51) "XNOR" ayant leurs propres sorties disposées à l'entrée d'un bloc logique (52) de type "AND" de façon à obtenir, à la sortie (52a) dudit bloc logique (52) de type "AND", une valeur logique "1" au niveau de l'intervalle de temps (ck1) dans lequel tous les bits de ladite première valeur numérique chiffrée (cnt1) sont égaux aux bits correspondants dudit signal numérique (S2);
- ledit bloc logique (52) de type "AND";
- un deuxième circuit électronique de stockage (53) connecté opérationnellement avec son entrée (53a) à la sortie (52a) dudit bloc logique (52) de type "AND", ledit deuxième circuit électronique de stockage (53) étant configuré pour commuter ledit deuxième signal de sortie (LS2) d'une première valeur à une deuxième valeur lorsque ladite sortie (52a) dudit bloc logique (52) de type "AND" est égale à "1", et pour maintenir ledit deuxième signal de sortie (LS2) constant à ladite deuxième valeur suite à ladite commutation, ledit deuxième circuit électronique de stockage (53) étant pourvu d'une sortie (53b) pour ledit deuxième signal de sortie (LS2).

11. Architecture de circuit selon l'une quelconque des revendications de 8 à 10, **caractérisée en ce que** ledit troisième groupe de comparaison logique (6) comprend:
- une première porte logique (61) de type "AND" configurée pour recevoir, en entrée, ledit premier signal de sortie (LS1) et le négatif dudit deuxième signal de sortie (LS2N);
- une deuxième porte logique (62) de type "AND" configurée pour recevoir, en entrée, le négatif dudit premier signal de sortie (LS1N) et ledit deuxième signal de sortie (LS2);
- une porte logique (63) de type "OR" configurée pour recevoir, en entrée, les sorties de ladite première porte logique (61) de type "AND" et de ladite deuxième porte logique (62) de type "AND" de façon à obtenir la valeur logique "1" pour une période de temps qui définit ladite plage temporelle (WIND) en entrée (63a), de ladite porte logique (63) de type "OR";
- un troisième circuit de stockage (64) connecté opérationnellement, avec son entrée (64a), à la sortie exclusivement de l'une parmi ladite première porte logique (61) de type "AND" et ladite deuxième porte logique (62) de type "AND", ledit troisième circuit de stockage (64) étant configuré pour commuter sa sortie (64b) d'une première valeur à une deuxième valeur et pour maintenir ladite sortie constante à ladite deuxième valeur si ladite entrée reçoit, en entrée, la valeur logique "1" de la porte logique de type "AND" à laquelle il est connecté.

12. Architecture de circuit (1) selon la revendication 11, **caractérisée en ce que** ledit deuxième compteur binaire (71) est connecté avec son entrée de validation (71a), avec ladite sortie (63a) de ladite porte logique (63) de type "OR" dudit troisième groupe de comparaison logique (6) de façon à générer et varier périodiquement ladite deuxième valeur numérique chiffrée (cnt2) pendant ladite plage temporelle (WIND).

13. Architecture de circuit (1) selon l'une quelconque des revendications précédentes, **caractérisée en ce que** ledit quatrième groupe de comparaison logique (7) comprend:
- un nombre de portes logiques (72) de type "XNOR" égal au nombre de bits avec lesquels ladite deuxième valeur numérique chiffrée (cnt2) et ladite valeur de seuil (DELTA) prédéterminée sont définies, chacune desdites portes logiques (72) "XNOR" étant configurée pour recevoir, en entrée, des bits ayant la même position que ladite deuxième valeur numérique chiffrée (cnt2) et que ladite valeur de seuil (DELTA) prédéterminée, la totalité desdites portes logiques (72) "XNOR" ayant leurs propres sorties disposées à l'entrée d'un bloc logique (73) de type "AND" de façon à obtenir, à la sortie (73a) dudit bloc logique (73) de type "AND", une valeur logique "1" au niveau de l'intervalle de temps desdits deuxièmes intervalles de temps (ck2) dans lequel tous les bits de ladite deuxième valeur numérique chiffrée (cnt2) sont égaux aux bits correspondants de ladite valeur de seuil (DELTA) prédéterminée;
- ledit bloc logique (73) de type "AND";
- un quatrième circuit électronique de stockage (74) connecté opérationnellement avec son entrée (74a) à la sortie (73a) dudit bloc logique (73) de type "AND", ledit quatrième circuit électronique de stockage (74) étant configuré pour commuter ledit troisième signal de sortie (SET) d'une première valeur à une deuxième valeur lorsque ladite sortie (73a) dudit bloc logique (73) de type "AND" est égale à "1", et pour maintenir ledit troisième signal de sortie (SET) constant à ladite deuxième valeur suite à ladite commutation, ledit quatrième circuit électronique de stockage (74) étant pourvu d'une sortie (74b) pour ledit troisième signal de sortie (SET).
